Europäisches Patentamt

European Patent Office

Office européen des brevets

(11) Publication number: **0 069 534**
**B1**

(12) **EUROPEAN PATENT SPECIFICATION**

(45) Date of publication of patent specification: **14.01.87**

(21) Application number: **82303428.5**

(22) Date of filing: **30.06.82**

(51) Int. Cl.⁴: **H 03 K 19/195, H 03 K 17/92**

(54) **Superconducting logic circuit.**

(30) Priority: **01.07.81 JP 101221/81**

(43) Date of publication of application:
**12.01.83 Bulletin 83/02**

(45) Publication of the grant of the patent:
**14.01.87 Bulletin 87/03**

(84) Designated Contracting States:
**DE FR GB NL**

(56) References cited:
**EP-A-0 024 468**
**US-A-4 275 314**

**IBM TECHNICAL DISCLOSURE BULLETIN, vol.
24, no. 1B, June 1981, pages 736-737, New
York, USA, A. MUKHERJEE : "Direct coupled or
gate"**
**JAPANESE JOURNAL OF APPLIED PHYSICS,
vol. 19, suppl. 19-1, 1980, pages 607-611,
Tokyo, JP. S. TAKADA et al: "Current injection
logic gate with four Josephson junctions"**

(73) Proprietor: **Hitachi, Ltd.**
**5-1, Marunouchi 1-chome
Chiyoda-ku Tokyo 100 (JP)**

(72) Inventor: **Kotera, Nobuo
2-18-3-301, Minami-cho
Kokubunji-shi Tokyo (JP)**
Inventor: **Hatano, Juji
4-1-2, Hiyoshi-cho
Kokubunji-shi Tokyo (JP)**
Inventor: **Asano, Atsushi
1-47-3-F302, Akatsuki-cho
Hachioji-shi Tokyo (JP)**
Inventor: **Kawabe, Ushio
1-8-46, Sakae-cho Hamuramachi
Nishitama-gun Tokyo (JP)**

(74) Representative: **Calderbank, Thomas Roger
et al**
**MEWBURN ELLIS & CO. 2/3 Cursitor Street
London EC4A 1BQ (GB)**

Courier Press, Leamington Spa, England.

## Description

The present invention relates to a superconducting logic circuit.

Attempts have been made to design a superconducting logic circuit which uses Josephson junctions so that it may be driven by a d.c. power source. Most of such attempts have made the presence or absence of a current signal correspond to logic values '1' and '0' respectively, but it is also possible to use positive and negative currents corresponding to the logic values '1' and '0' respectively.

One such superconducting logic circuit is the Hybrid Unlatching Flip-Flop Logic Element circuit (hereinafter abbreviated to HUFFLE circuit) disclosed in the article by A. E. Hebard, et al. entitled "A DC-Powered Josephson flip-flop", in the journal IEEE Trans. MAG-15, (1)408(1979); the article by T. A. Fulton, et al, entitled "Josephson junction current-switched logic circuits", in the journal IEEE Trans. MAG-15, (6)1876(1979); and the article by S. S. Pei, entitled "Current-switched Josephson flip-flop logic", in 1979-MTT-S, International Microwave Symposium Digest, 21.

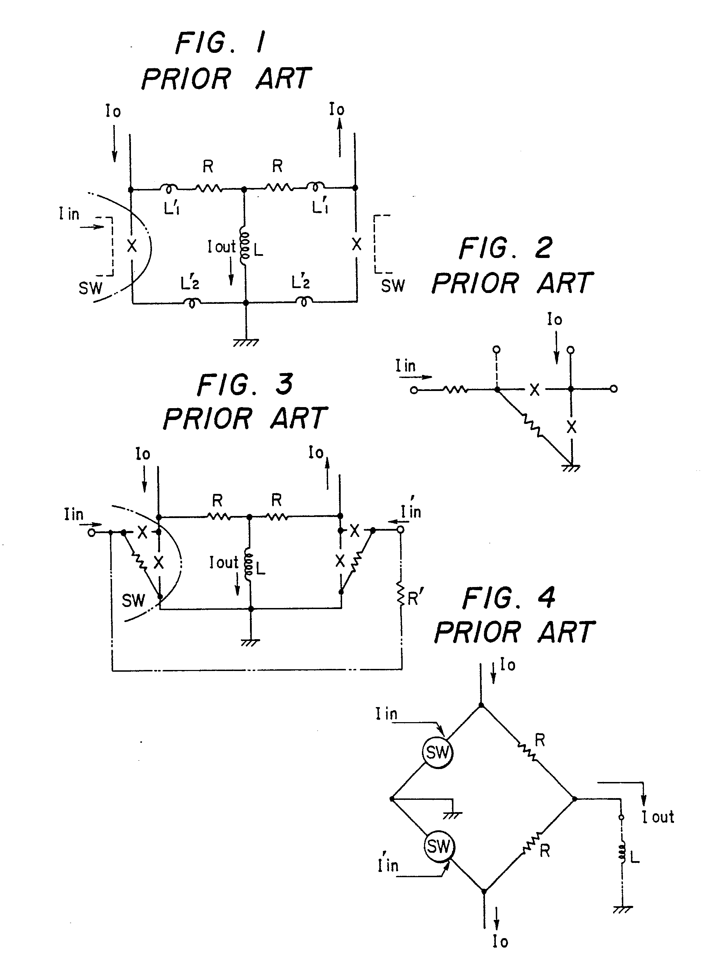

The HUFFLE circuit is driven by power sources formed by a current source and a current sink, as shown in Fig. 1 of the accompanying drawings, and those power sources may be of the d.c. type. Two superconducting switching devices SW are connected on the respective power source terminals, the two superconducting switching devices SW having their other terminals earthed. Two identical resistors R are also connected to the power source terminals with their other terminals connected to each other to provide an output terminal. As a result, a positive or negative output current $I_{out}$ is generated at an inductive load (which has an inductance L) in response to the input signals of the switching devices which are located at the righthand and lefthand sides of the Figure. Fig. 1 therefore shows an example in which the simplest Josephson junctions (which are indicated at X in the drawing) are used as the switching devices. Input signal currents flow through the control lines, (which are indicated by broken lines in Fig. 1), so that magnetic fluxes are generated which control the operations of the junctions.

If an input is supplied to the lefthand junction in Fig. 1, so that it is transferred from a superconducting state (i.e., a zero-voltage state) to a non-zero voltage state (hereinafter referred to as a voltage state) the current $I_o$ of the lefthand current source cannot flow directly to earth but flows through the load inductance L so that a positive output current $I_{out}$ is obtained. Since, at this time, the righthand junction is at its superconducting state, the current of the righthand current source flows unchanged from earth to the power source but does not appear at the output terminal.

Next if an input is supplied to the righthand junction, so that it is transferred to a voltage state, circuit is changed to the opposite state to that previously described. As a result, the current to the sink flows through the load inductance L so that a negative output current $I_{out}$ is obtained. The fact that the lefthand junction is returned to its voltage state at the instant of the transfer is the most fundamental feature of the operation of a HUFFLE circuit. As has been briefly described in the above, the known HUFFLE circuit has two separate input terminals so that it can generate an output signal corresponding to an input signal when either (not both) of its input terminals receives that input signal, and can maintain that state even after the input disappears. As a result, the HUFFLE circuit can be used as a flip-flop circuit. In Fig. 1, there are shown parasitic inductances $L_1'$ and $L_2'$ which accompany the junction circuit but may be considered to be negligible (or to be zero).

If the HUFFLE circuit thus described is used as a logic gate, however, there arises the following problem. If a first input is applied to the lefthand switching device, a subsequent second input has to be applied to the righthand switching device after a predetermined time has elapsed. If the second input is applied to the lefthand switching device, the circuit does not respond. In order to eliminate this defect, complementary inputs may be simultaneously applied to the righthand and lefthand input terminals. Thus, to overcome the defect it is sufficient to ensure that a logic value "1" (or "0") is never fed to the lefthand input terminal except when a logic value "0" (or "1") is simultaneously fed to the righthand input terminal. From the standpoint of the construction of a logic circuit, however, it is highly wasteful to provide the aforementioned "complementary input signals" at all times.

It is known to replace the simple junction, forming the switching device, by a superconductive switch known as a Josephson Atto-Weber Switch (hereinafter abbreviated to JAWS). This is described in the article by T. S. Stakelon, entitled "Current switched Josephson latching logic gates with sub-100 ps delays" in the periodical IEEE Trans. MAG-15, (6)1886(1979). Such a switch is shown in Fig. 2 of the accompanying drawings.

When operating such a switch, an input current $I_{in}$ is injected directly into an active portion of the device but the input is not received in the form of a magnetic flux, as in the junction switch previously described.

A HUFFLE circuit utilizing a JAWS as the switching device is called a "JAWS-HUFFLE" and is shown in Fig. 3 of the accompanying drawings. According to the articles referred to above, any device can be used as the "switching device" if it can produce the necessary two states, i.e., the superconducting state (i.e. the zero voltage state) and the voltage state and if the current which is to flow through the switching device is sufficiently less than the current in the superconducting state. Therefore, a HUFFLE circuit can be constructed by using the CIL gate disclosed in U.S. Patent Specification No. 4 117 503 as the switching device.

From the foregoing discussion it is apparent that a HUFFLE circuit cannot be operated without preparing the "complementary input signals". In the article by T. A. Fulton referred to above, it is mentioned that a HUFFLE circuit can be operated using only one input by connecting two input terminals $I_{in}$ AND $I'_{in}$ by means of a resistor $R'$, as indicated by broken line in Fig. 3, instead of providing "complementary input signals". However, it has been found that it is not easy to design the circuit operating point with such an arrangement.

All of the prior art examples previously described, if summarized, can be thought of as a kind of the "bridge type logic circuit", in which the two superconducting switching devices SW and the two resistors R are connected in the form of a Wheatstone bridge, as shown in Fig. 4 of the accompanying drawings.

The present invention as defined in the claims seeks to provide a d.c. power source driven bridge type logic circuit which has an input circuit construction which does not require "complementary input signals". The present invention may also provide a superconducting logic circuit of which high speed and high gain, which can achieve logic functions such as AND or OR functions.

The present invention modifies the known bridge type logic circuit by providing a single input terminal formed by the junction of two resistances, the opposite ends of which are connected to respective control terminals of the superconducting switching devices.

In actual use as the logic circuit, a plurality of logic inputs are connected to the input terminal so that an OR or AND logic output can be obtained from those inputs. Alternatively a similar logic output can be obtained if another input circuit composed of resistors having a resistance similar to the third and fourth resistances is connected in parallel with the input circuit composed of those third and fourth resistances such that the node of those input circuits form the logic input terminal. In either case, terminals of the resistances which are connected to the first and second switching devices, respectively, are connected to each other to provide the logic input terminal.

According to the logic circuit of the present invention thus far described, a logic integrated circuit utilizing Josephson junctions can be constructed and driven by a d.c. power source. The inputs can be combined into a single input so that an input can be applied uniformly through the two switching devices and the two resistances. As a result, the circuit of the present invention can be made completely symmetric with respect to earth so that the output can be balanced to zero by the complete symmetry of the bridge at all times when there is no input signal.

The logic circuit of the present invention can be used as an integrated circuit in a high speed computer.

Embodiments of the present invention will now be described in detail, by way of example, with reference to the accompanying drawings, in which:

Figs. 1 to 4 are circuit diagrams showing prior art superconducting logic circuits, and have already been discussed;

Fig. 5A is a circuit diagram showing a first embodiment of the superconducting logic circuit of the present invention;

Figs. 5B and 5C are circuit diagrams illustrating two alternative input connecting methods for the circuit of Fig. 5A;

Figs. 6A and 6B are circuit diagrams showing examples of the switching device to be used in the superconducting logic circuit of the present invention;

Figs. 7A and 7B are graphs illustrating the operational requirements of the switching devices of Figs. 6A and 6B, particularly the ranges of certain parameters; and

Figs. 8 and 9 are circuit diagrams showing two other embodiments of the superconducting logic circuit of the present invention.

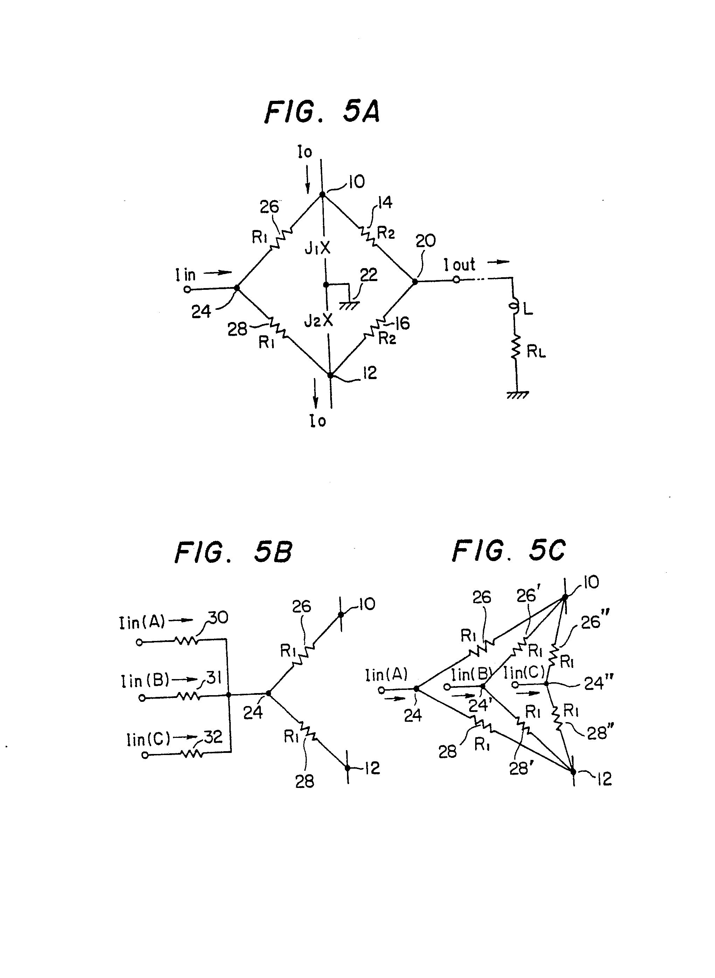

Fig. 5A shows the fundamental circuit according to a first embodiment of the present invention. A current source and a current sink are connected to a power source terminal 10 and a power source terminal 12, respectively. Josephson junctions J1 and J2 are connected between the power source terminal 10 and earth 22 and between the power source terminal 12 and the earth 22, respectively. Two resistors, 14 and 16, having equal resistances $R_2$ are connected between the power source terminal 10 and a logic output terminal 20 and between the power source terminal 12 and the logic output terminal 20, respectively. Input resistors 26 and 27, having equal resistances $R_1$ are connected between the power source terminal 10 and a logic input terminal 24 and between the power source terminal 12 and the logic input terminal 24, respectively.

In Fig. 5A, when an input current $I_{in}$ (which is positive or negative) is applied to the logic input terminal 24, one junction (e.g., J1 or J2) has its internal current increased whereas the other junction (e.g. J2 or J1) has its internal current decreased. The current $I_o$ of the power source is set so that the two junctions are in the superconducting state (i.e., in the zero voltage state) for $I_{in}=0$. For $I_{in}=0$, one of the junctions has its internal current increased to exceed a critical current (or maximum supercurrent) $I_m$, which is intrinsic to the junction so that it can be switched to the voltage state. Simultaneously, the internal current of the other junction does not exceed the critical current $I_m$ so that it is in the superconducting state (i.e., the zero voltage state). Both junctions are designed to have equal critical current $I_m$. The output current $I_{out}$ is then independent of resistance $R_1$ of resistors 26, 28. If the voltage to be generated at both terminals of a junction is expressed by a function f and if that junction has a current $I_g$, the output current $I_{out}$ is expressed by the following equation (by a d.c. analysis):

$$I_{out} = \frac{f(I_{g1}) - f(I_{g2})}{2R_L + R_2} \tag{1}$$

where:

$R_L$ is the resistance component of the load impedance and is considered to be zero (however, the setting of $R_L \neq 0$ increases the power consumption of the circuit but is effective to shorten the circuit delay time);

$I_{g1}$ is the internal current flowing through the junction J1 toward earth; and

$I_{g2}$ is the internal current flowing through the junction J2 from earth to the power source.

The function f may be approximated in the following form for simplicity:

$$f(I_g) = \begin{cases} V_g & \text{(in the voltage state)} \\ 0 & \text{(in the zero voltage state)}, \end{cases}$$

$$0 \leq I_g \leq I_m) \tag{2}$$

where $V_g$ is the gap voltage of the junction, which has value determined by the superconducting material used. In the normal operational mode, the output of the circuit of the present invention can be expressed utilising the quantity $\delta$ defined by

$$\delta = \frac{1}{2(2R_L + R_2)} \tag{3}$$

The output becomes:

$$\text{(i) } I_{in} > 0, \; f(I_{g2}) = 0, \; I_{out} = 2\delta V_g, \tag{4}$$

$$\text{(ii) } I_{in} < 0, \; f(I_{g1}) = 0, \; I_{out} = 2\delta V_g, \tag{5}$$

for $I_{in} = 0$, the circuit is in its stand-by state, and

$$f(I_{g1}) = f(I_{g2}) = 0 \text{ and } I_{out} = 0.$$

In an erroneous operational mode, on the other hand,

$$f(I_{g1}) = f(I_{g2}) = V_g \text{ and } I_{out} = 0$$

may occur. (This is called the "hung up" state of the circuit and is generally prevented by suitable circuit design). As is apparent from equations (1), (4) and (5), the output $I_{out}$ is independent of the resistance $R_1$ of the input resistors 26, 28, provided that the input resistors 26 and 28 are arranged symmetrically with respect to earth, as shown in Fig. 5A.

As a result, two (or more) input currents such as $I_{in}(A)$, $I_{in}(B)$ and $I_{in}(C)$ can be introduced to the circuit input system of the present invention by the circuitry shown in Figs. 5B and 5C. Then the following equation holds:

$$I_{in} = I_{in}(A) + I_{in}(B) + I_{in}(C). \tag{6}$$

In the circuit of Fig. 5B, the logic input terminal 24 is supplied with the input currents $I_{in}(A)$, $I_{in}(B)$ and $I_{in}(C)$, through resistors 30, 31 and 32 respectively. In the circuit of Fig. 5C, on the other hand, a second input circuit composed of input resistors 26' and 28' and a third input circuit composed of input resistors 26" and 28" are connected in parallel with the input circuit composed of the input resistors 26 and 28, and their respective nodes provide the logic input terminals. A plurality of input logics such as AND or OR logics are formed by both the configurations of Figs. 5B and 5C, respectively.

The operational requirements for the circuit of the present invention will now be described in detail. By solving the circuit equations, the internal currents $I_{g1}$ and $I_{g2}$ and the output current $I_{out}$ of the junctions J1 and J2 are written (by the d.c. solutions) as follows:

$$I_{g1} = (I_o + \frac{I_{in}}{2}) - 2\delta f(I_{g1}) - (\gamma - \delta) \cdot \{f(I_{g1}) + f(I_{g2})\}, \tag{7}$$

$$I_{g2} = (I_o - \frac{I_{in}}{2}) - 2\delta f(I_{g2}) - (\gamma - \delta) \cdot \{f(I_{g1}) + f(I_{g2})\}, \tag{8}$$

4

$$I_{out}=2\delta\{f(I_{g1})-f(I_{g2})\}, \tag{9}$$

where $\gamma$ is defined by the identity:

$$\gamma\equiv\delta X\frac{R_1R_2+2R_L(R_1+R_2)+R_2^2}{R_1R_2}. \tag{10}$$

Here, the value $\gamma$ is defined by equation 3 ($\gamma>\delta$). If the approximation of the equation 2 is used as the function f, the currents $I_{g1}$, $I_{g2}$ and $I_L$ take values which are tabulated in Table 1, in dependence upon the values $f(I_{g1})$ and $f(I_{g2})$:

TABLE 1

| Situation | $f(I_{g1})$ | $f(I_{g2})$ | $I_{g1}$ | $I_{g2}$ | $I_{out}$ |
|---|---|---|---|---|---|
| 1 | 0 | 0 | $I_o+I_{in}/2$ | $I_o-I_{in}/2$ | 0 |
| 2 | $V_g$ | 0 | $(I_o+\frac{I_{in}}{2})-(\gamma+\delta)V_g$ | $(I_o-\frac{I_{in}}{2})-(\gamma-\delta)V_g$ | $2\delta V_g$ |
| 3 | 0 | $V_g$ | $(I_o+\frac{I_{in}}{2})-(\gamma-\delta)V_g$ | $(I_o-\frac{I_{in}}{2})-(\gamma+\delta)V_g$ | $-2\delta V_g$ |
| 4 | $V_g$ | $V_g$ | $(I_o+\frac{I_{in}}{2})-2\gamma V_g$ | $(I_o-\frac{I_{in}}{2})-2\gamma V_g$ | 0 |

In the "stand-by state" of the circuit where $I_{in}=0$ (i.e. situation 1) it is necessary that both the junctions J1 and J2 should not be in the voltage state nor be hung up. To achieve this the following relationship is a first "necessary condition":

$$I_{in}\geq I_o \tag{11}$$

In other words, the bias current of the power source should not exceed the critical current (i.e., the maximum superconducting tunnel current) $I_m$ intrinsic to the junctions. Next, there is the switching requirement, so that, for $|I_{in}|\neq0$, one junction may be in the voltage state whereas the other may be in the zero voltage state (i.e., situations 2 and 3), the following relationships are required:

$$I_o+\frac{|I_{in}|}{2}-(\gamma+\delta)\cdot V_g>I_m\geq I_o-\frac{|I_{in}|}{2}-(\gamma-\delta)\cdot V_g. \tag{12}$$

From the first and third terms of the equation 12, the following inequality must hold as the second "necessary condition":

$$|I_{in}|>2\delta V_g. \tag{13}$$

Since the third term of the equation 12 is trivial with the equation 13, the following inequality becomes a third "necessary condition":

$$\frac{|I_{in}|}{2}>(I_m-I_o)+(\gamma+\delta)\cdot V_g. \tag{14}$$

If the equation 14 holds, the following inequalities are obtained:

$$\frac{|I_{in}|}{2}>I_m-I_o>0. \tag{15}$$

With the relationship of the equation 15, when the input $I_{in}$ ($\neq0$) is applied (which corresponds to situation 1), one of the junction currents is transferred to the voltage state and exceeds the value $I_m$, whereas the other remains in the zero voltage state:

$$I_g = I_o \pm \frac{|I_{in}|}{2}. \tag{16}$$

In other words, the situation can be transferred from states 2 and 3, and the circuit can be started.

From the foregoing description, it is evident that the necessary conditions for operating the circuit of the present invention can be expressed by equations 11 and 14. (The necessary condition 13 is contained in equation 14. Furthermore since $\gamma > \delta$, if either the following relationship (more strict than equation 12) holds:

$$I_o + \frac{|I_{in}|}{2} - 2\gamma V_g > I \geqq I_o - \frac{|I_{in}|}{2} - 2\gamma V_g,$$

or if the following inequality holds:

$$\frac{|I_{in}|}{2} > (I_m - I_o) + 2\gamma V_g, \tag{17}$$

then it is found that the "hung up" condition is unlikely to occur when the range of parameters is within the normal operating condition of the circuit (see the values $I_{g1}$ and $I_{g2}$ of equation 4). With the necessary condition expressed by the inequality 13, therefore, the following inequality holds with reference to Table 1:

$$|I_{in}| > |I_{out}|. \tag{18}$$

In the present circuit, the output current ($I_{out}$) becomes smaller than the total input current. In order to improve this, it is sufficient to generate a gain by using a CIL gate or a switching device to be described later as the "switching device" rather than the single junction.

Next, the operation of the circuit of the present invention as an OR or AND logic element of two inputs will be described. In this description it will be assumed that the input connections are of the form shown in Fig. 5B or 5C so that the three paired inputs $I_{in}(A)$, $I_{in}(B)$ and $I_{in}(C)$ may be introduced. The levels of those input currents are normalised with reference to the necessary condition 14, as follows:

$$I_{det} = 2(I_m - I_o) + (\gamma + \delta) \cdot V_g. \tag{19}$$

When the absolute value of the following total input current exceeds a value $I_{det}$, the circuit is operated:

$$I_{in} = I_{in}(A) + I_{in}(B) + I_{in}(C). \tag{20}$$

Here, the design is made such that the "unit input" takes $\pm 1.2\, I_{det}$ and that no zero input occurs during the operation. The logic value "1" corresponds to an input of $1.2\, I_{det}$, whereas the logic value "0" corresponds to an input of $-1.2\, I_{det}$. The output corresponds to the logic value "1" for a current of $2\delta V_g$ and the logic value "0" for a current of $-2\delta V_g$. Here, the output responses when various logic values are fed to the respective inputs A, B and C are as set out in Table 2. The circuit of the embodiment of the present invention constructs majority logic for the three inputs A, B and C in accordance with the equation 20. Therefore, if the input $I_{in}(C) = 1.3\, I_{det}$ at all times, OR operation of the two inputs A and B can be achieved (i.e., situations 1 to 4 of Table 2). In Table 2 the inputs are expressed by using the $I_{det}$ as one unit current, and the logic values are expressed by bracketed numerals:

6

TABLE 2

| Situation | $I_{in}(A)$ | $I_{in}(B)$ | $I_{in}(C)$ | Total $I_{in}$ | $I_{out}$ | Remarks |
|---|---|---|---|---|---|---|
| 1 | 1.2(1) | 1.2(1) | 1.2(1) | 3.6 | $2\delta V_g(1)$ | |
| 2 | 1.2(1) | −1.2(0) | 1.2(1) | 1.2 | $2\delta V_g(1)$ | OR Operations for inputs A & B |
| 3 | −1.2(0) | 1.2(1) | 1.2(1) | 1.2 | $2\delta V_g(1)$ | |
| 4 | −1.2(0) | −1.2(0) | 1.2(1) | −1.2 | $−2\delta V_g(0)$ | |
| 5 | None | None | 1.2(1) | 1.2 | $2\delta V_g(1)$ | Stand-by for OR operation |
| 6 | 1.2(1) | 1.2(1) | −1.2(0) | 1.2 | $2\delta V_g(1)$ | |
| 7 | 1.2(1) | −1.2(0) | −1.2(0) | −1.2 | $−2\delta V_g(0)$ | AND Operations for inputs A and N |
| 8 | −1.2(0) | 1.2(1) | −1.2(0) | −1.2 | $−2\delta V_g(0)$ | |
| 9 | −1.2(0) | −1.2(0) | −1.2(0) | −3.6 | $−2\delta V_g(0)$ | |
| 10 | None | None | −1.2(0) | −1.2 | $−2\delta V_g(0)$ | Stand-by for AND operation |
| 11 | None | None | None | 0 | 0 | Stand-by with no input |

Alternatively, if the input is always $I_{in}(C)=-1.2\ I_{det}$, AND operation for the two inputs A and B can be achieved (i.e. situations 6 to 9 of Table 2). Situations 5 and 10 of Table 2 are the stand-by states for the OR and AND operations respectively. Likewise, situation 11 indicates that the output becomes zero when only the power source current $I_o$ is applied to the circuit, and no current signal is fed to any of the input terminals A, B and C.

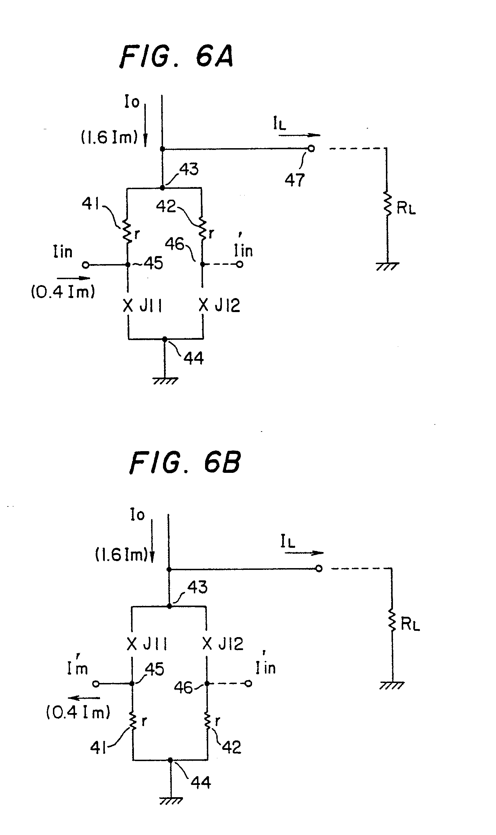

A superconducting switching device which is suitable for use in the logic circuit of the present invention will now be described in detail with reference to Figs. 6A and 6B. This switching device is used as an alternative to the Josephson junctions J1 and J2 in the circuits shown in Fig. 5A to 5C. This switching circuit can also be applied to the known HUFFLE circuit or with a circuit element of the "a.c. power source drive" type, which is not d.c. power source drive but reduces the power source current each time one logic calculation is completed.

The switching device shown in Fig. 6A is constructed by connecting in parallel a series circuit composed of a Josephson junction J11 and a resistor 41 having a resistance r, and a series circuit which is composed of a Josephson junction J12 and a resistor 42 having a resistance r. The parallel connection thus constructed is earthed at its node 44 at the Josephson junction side and is connected to a current source (or a current sink) at its node 43 at the resistor side. The node 45 between the resistor 41 and the junction J11 and/or the node 46 between the resistor 42 and the junction J12 are used as an input terminal or input terminals, into which the input current $I_{in}$ is injected. This current may be positive or negative. The output signal current $I_L$ is derived from the output terminal 47 which is connected to the node 43 between the current source (or the current sink) and the parallel connection.

In the switching device shown in Fig. 6B, the construction is similar to that of the switching device of Fig. 6A except that the earthed terminal and the power source terminal are interchanged.

The operations of those switching devices will now be described by using simple numerical values by way of example. (If the internal current of the junction exceeds the value $I_m$, the junction is transferred from the superconducting state or the zero voltage state to the voltage state). If a power source current of $I_o=1.6$ $I_m$ is used, when both junctions J11 and J12 are supplied with no input, they permit a current of 0.8 $I_m$ to flow therethrough so that they are in the zero voltage state. If an input current of $I_{in}=0.4\ I_m$ is injected in a direction to increase the internal current of the junction J1, an internal current as large as 1.2 $I_m$ flows through one junction J11 at that instant, so that the junction J11 is transferred to the voltage state. If the internal current of the junction J11 is considered to be approximately zero, a current of 2.01 $I_m$ flows through the inside of the other junction J12. As a result, the junction J12 is subsequently transferred to the voltage state. Since both the junctions J11 and J12 are in the voltage states so that a small current flows therethrough, most of the power source current of $I_0=1.6\ I_m$ can flow out of the output terminal 47. To ensure this the load resistor $R_L$ (or the impedance) connected to the output terminal 47 should not be excessively low. If the ratio of $I_L/I_{in}$ is called the "gain", the gain takes a value 4 so that a larger output current than input current is generated.

The operating conditions of the switching device will now be described in detail. If the circuit equations are solved, the output current $I_L$ and the internal currents $I_1$ and $I_2$ of the junctions J11 and J12 can be written as follows (by d.c. analysis):

$$I_1 = I_{in} + p\{I_o = (f_1 + f_2)/r\} - f_1/r, \tag{21}$$

$$I_2 = p\{I_o + (f_1 + f_2)/r\} - f_2/r, \tag{22}$$

$$I_L = q\{I_o + (f_1 + f_2)/r\} \tag{23}$$

where the quantities p and q are defined by the following equations:

$$p = R_L/(2R_L + r) \qquad q = r/(2R_L + r). \tag{24}$$

Reference symbols and approximations correspond to those used in the previous analysis, with $f_1$ and $f_2$ representing abbreviations of the functions $f(I_1)$ and $f(I_2)$. The letters p and q are abbreviations of $p(2)$ and $q(2)$. If this approximation of equation 2 is carried out on the function f, the currents $I_1$, $I_2$ and $I_L$ take the values tabulated in Table 3. The foregoing equations are common and mathematically equivalent if the direction of the current $I_{in}$ is defined to be that indicated by the arrows in Figs. 6A and 6B.

TABLE 3

| Situation | $f(I_1)$ | $f(I_2)$ | $I_1$ | $I_2$ | $I_L$ |
|---|---|---|---|---|---|
| 1 | 0 | 0 | $I_{in} + pI_o$ | $pI_o$ | $qI_o$ |
| 2 | $V_g$ | 0 | $I_{in} + pI_o - (1-p)V_g/r$ | $p(I_o + V_g/r)$ | $q(I_o + V_g/r)$ |
| 3 | 0 | $V_g$ | $I_{in} + p(I_o + V_{G/r})$ | $pI_o - (1-p)V_g/r$ | $q(I_o + V_g/r)$ |
| 4 | $V_g$ | $V_g$ | $I_{in} + PI_o - (1-2p)V_g/r$ | $pI_o - (1-2p)V_g/r$ | $q(O_p + 2V_g/r)$ |

On the basis of these calculations, the necessary conditions for switching the switching device to be used in the present invention may be determined. In the "stand-by state" of the switching device where $I_{in} = 0$ (i.e., the situation 1), in order that both the junctions J11 and J12 may be prevented from being brought into the voltage state and from being hung up, $p(2)I_o = I_m$, i.e., the following relationship is the first "necessary condition":

$$R_L I_o = (2R_L + r)I_{in}. \tag{25}$$

When this relationship holds, the junctions J11 and J12 can stand by in the zero voltage state. Next, for $I_{in} \neq 0$, in order that the junction J11 be brought into the voltage state, $p(2)I_o + I_{in} = I_m$, i.e., the following relationship is necessary, which provides the second "necessary condition":

$$R_L I_o > (2R_L + r)(I_m - I_{in}). \tag{26}$$

Thus if the current $I_{in}$ satisfying inequality 26 is applied to the device, the junction J11 is transferred from situation 1 ($f(I_1) = 0$) to situation 2 ($f(I_1) = V_g$) as tabulated in Table 3. In accordance with this transfer, the value $I_1$ is decreased from its initial value whereas the value $I_2$ is increased, as is tabulated in the column of situation 2 of Table 3. However, the junction J11 is maintained at the voltage state. If, at this time, the other junction J12 is transferred to the voltage state, the desired switching operation is effected. The necessary condition for this is that the value $I_2$ exceeds $I_m$, and $p(2) \times (I_o + V_g/r) > I_m$, i.e., the following inequality must hold as the third "necessary condition":

$$R_L(I_o + V_g/r) > (2R + r)I_m. \tag{27}$$

If this condition is satisfied, the switching device is started by the input $I_{in}$ ($>0$) in the course of situations 1, 2 and 4. At this time, the values $I_1$ and $I_2$ are increased and decreased, as tabulated in the column of situation 4 of Table 3, but both the junctions are maintained in the voltage state. The output finally to be obtained from that switching device is equal to $q(2) \times (I_o + 2V_g/r)$, i.e., the following equation:

$$I_L = \{r/(2R_L + r)\}(I_o + 2V_g/r). \tag{28}$$

As has been described hereinbefore, the necessary conditions for operating the switching device used in the present invention are expressed by the equations 25, 26 and 27. If a power source current satisfying equations 25 and 27 is selected and if the current $I_{in}$ satisfying equation 26 is applied to the device, the switching device can accomplish the desired operations. Now, if $R_L \gg r$ is assumed as a simple approximation, $p(2) \approx 1/2$ holds. Hence, those three equations can be summarised in the following forms:

$$\left( \frac{I_o}{2I_m} + \frac{I_{in}}{I_m} \right) > 1, \tag{29}$$

$$2 \geqslant \frac{I_o}{I_m} > \left(2 - \frac{V_g}{rI_m}\right). \tag{30}$$

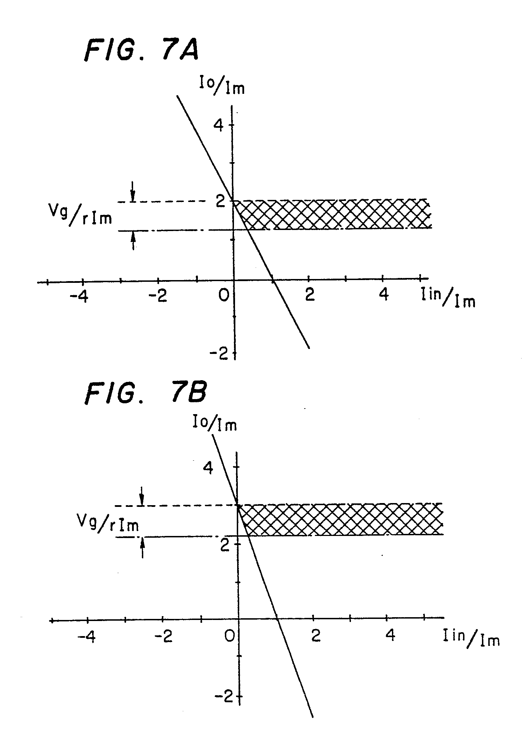

The range of the variables $I_{in}$, $I_o$, satisfying these inequalities is given by the hatched portion in Fig. 7A. In other words, if the power source current is selected to have a value $I_o$ satisfying inequality 3, the switching device accomplishes the desired operations.

If however $R_L = r$, then $p(2) = 1/3$ and equations 25, 26 and 27 may be summarised as follows:

$$\left( \frac{I_o}{3I_m} + \frac{I_{in}}{I_m} \right) > 1, \tag{31}$$

$$3 \geqslant \frac{I_o}{I_n} > \left(3 - \frac{V_g}{rI_m}\right). \tag{32}$$

The ranges of the variables $I_{in}$, $I_o$ satisfying these inequalities are shown by the hatched portion in Fig. 7B.

Under these conditions, $q(2) = 1/3$ and the output current may be expressed by the following equation:

$$I_L = 1/3(L_o + 2V_g/r). \tag{33}$$

If a suitable operating point is selected, it is possible to select the logic swing of $2q(2)V_g/r$ of the output at a higher level than the input $I_{in}$. The calculated results thus obtained can be applied to both the switching devices shown in Figs. 6A and 6B. Here, the direction of $I_{in}$ ($>0$) is the direction of the source in Fig. 6A and the direction of the sink in Fig. 6B.

The switching devices thus far described with reference to Fig. 6A and 6B show an arrangement in which two combinations of the resistor and the Josephson junction are connected in parallel. However, that construction can be extended to a general one in which a number N of combinations are connected in parallel. If the switching device is composed of $N(N \geqslant 2)$ combinations in parallel, the output current obtainable can be generally increased in relation to the number M.

In this example of a switching device having N parallel circuits, the input current $I_{in}$ is assumed to be applied to the first parallel circuit. At this time, the first current $I_1$, the kth current $I_k$ and the load current $I_L$ are expressed by the following equations, respectively:

$$I_1 = I_{in} + p\left\{ I_o + \frac{\sum_{j=1}^{N} f_j}{r} \right\} - \frac{f_1}{r}, \tag{34}$$

$$I_k = p\left\{ I_o + \frac{\sum_{j=1}^{N} f_j}{r} \right\} - \frac{f_k}{r}, \tag{35}$$

$$I_L = q\left\{ I_o + \frac{\sum_{j=1}^{N} f_j}{r} \right\}. \tag{36}$$

Here, $j = 1, \ldots, N$, and $k = 2, \ldots, N$, and the $p(N)$ and $q(N)$ are defined as follows:

$$p(N)=\frac{R_L}{N_{RL}+r} \qquad q(N)=\frac{r}{NR_L+r}. \qquad (37)$$

where $f_1$ and $f_j$ are abbreviations of the functions $f(I_1)$ and $f(I_j)$, and p and q are abbreviations of p(N) and q(N). The approximation of equation 2 has been used for the function f.

The switching requirement for the switching device using N parallel circuits can be given by the following three relationships similar to equations 25, 26 and 27 for N=2. That is to say:

$$\text{From } p(N)I_o \leq I_m: \quad R_L\, I_o \leq (NR+r)I_m. \qquad (38)$$

$$\text{From } p(N)I_o + I_{in} > I_m: \quad R_L I_o > (NR+r)(I_m = I_{in}). \qquad (39)$$

$$\text{From } P(N) \ (I_o + V_g/r) > I_m: \quad R_L \ (I_o + V_g/r) > (NR_L + r)I_m. \qquad (40)$$

The output current when the switching operation takes place so that all the junctions are in the voltage state may be obtained from the following equation:

$$I_L = (rI_o + NV_g)/(NR_L + r), \qquad (41)$$

The increment of the output $I_L$ by the input current $I_{in}$ ($\neq 0$) is given by $NV_g/(NR_L = r)$, which can be increased as the value of N (=2) becomes larger.

The switching devices thus far described are directed to an arrangement in which the input current $I_{in}$ is applied to the first junction only. However, similar effects can be obtained if the input current is fed to one of the other parallel circuits or simultaneously to all the parallel circuits.

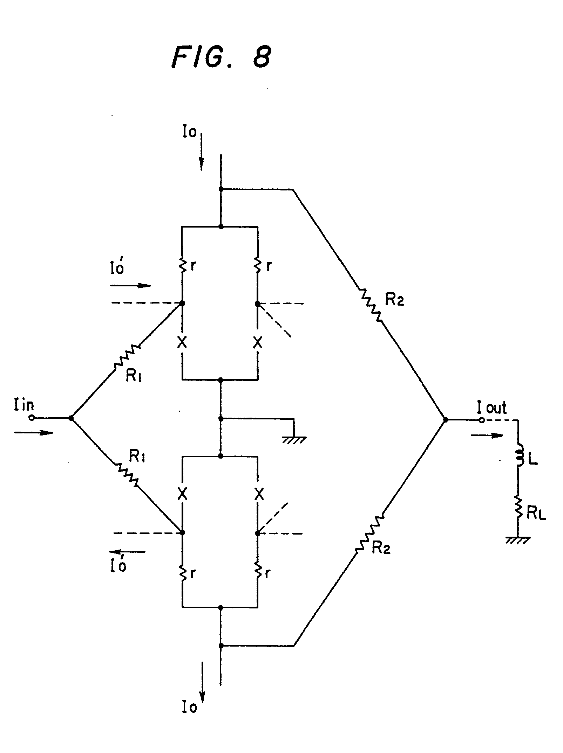

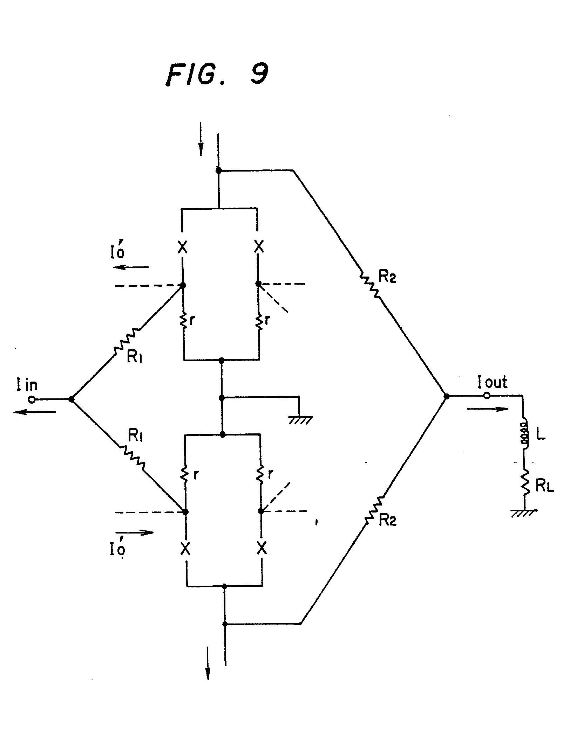

If the switching devices shown in Figs. 6A and 6B are applied to the logic circuit shown in Fig. 5A, the circuits of Figs. 8 and 9 are obtained respectively. In these examples, the single junctions J1 and J2 of Fig. 5A are replaced by the switching device of Fig. 6A or 6B. It is apparent that the operations of the aforementioned majority, AND and OR logics can be effected at high gains by those combinations. In the logic circuit of Fig. 5A, a CIL gate as previously mentioned may be adopted as the switching device, with the circuit having a construction similar to that of Fig. 8. In this modification, the resistor r of Fig. 8 is replaced by an inductance.

## Claims

1. A superconducting logic circuit comprising a first power source terminal (10) adapted to be connected to a current source, a second power source terminal (12) adapted to be connected to a current sink, a first superconducting switching device (J1) connected between the first power source terminal (10) and earth (22) a second superconducting switching device ($J_2$) connected between the second power source terminal and earth (22) and first and second resistances (14, 16) each having one terminal connected to the first and second power source terminals (10, 12) respectively, the other terminals of the first and second resistances (14, 16) being connected together to form an output terminal (20); characterised in that: the circuit includes third and fourth resistances (26, 28) each having one terminal connected to a control terminal of the first and second superconductive switching devices ($J_1, J_2$) respectively, the other terminals of the third and fourth resistances (26, 28) being connected together to form an input terminal (24).

2. A superconducting logic circuit according to claim 1, wherein said first and second resistances (14, 16) have an equal resistance.

3. A superconducting logic circuit according to claim 1 or claim 2, wherein said third and fourth resistances (26, 28) have an equal resistance.

4. A superconducting logic circuit according to any one of the preceding claims wherein said first and second superconducting switching devices ($J_1, J_2$) are Josephson junctions each of which has one terminal connected to a control input terminal.

5. A superconducting logic circuit according to any one of the preceding claims, further including a plurality of resistors (30, 31, 32) connected to the input terminal (24) of said third and fourth resistances (26, 28) and having their other terminals providing respective logic inputs.

6. A superconducting logic circuit according to any one of claims 1 to 4, wherein the third resistance (26) comprises a plurality of resistors (26, 26′, 26″) one end of each of those resistors (26, 26′, 26″) being connected to the first power source terminal (10), and the fourth resistance (28) comprises a plurality of resistors (28, 28′, 28″), one end of the resistors (28, 28′, 28″) of the fourth resistance being connected to the second power source terminal, the free end of each of the resistors (26, 26′, 26″) of the third resistance being connected to the free end of a corresponding resistance (28, 28′, 28″) of the fourth resistance to form a corresponding plurality of input terminals (24, 24′, 24″).

7. A superconducting logic circuit as set forth in claim 6, wherein all said resistors have an equal resistance.

8. A superconducting logic circuit according to any one of the preceding claims, wherein each of said

10

first and second superconducting switching circuits (J1, J2) includes a plurality of circuit units which are connected in parallel and each of which units has one Josephson junction (J11, J12) and a resistance (41, 42) and wherein the node (45, 46) between the Josephson junction (J11, J12) and the resistance (41, 42) of at least one of said circuit units provides a control terminal.

9. A superconducting logic circuit according to claim 8, wherein said plurality of circuit units are connected with either of said first and second power source terminals (10, 12) formed by the common terminal (43) of the plurality of circuit units on their Josephson junction side and are earthed at their common terminal (44) on their resistance side.

10. A superconducting logic circuit according to claim 8 wherein said plurality of circuit units are connected with either of said first and second power source terminals (10, 12) formed by the common terminal (43) of the plurality of circuit units on their resistance side and are earthed at their common terminal (44) of their Josephson junction side.

## Patentansprüche

1. Supraleitende logische Schaltung mit einem ersten Energiequellenanschluß (10), der mit einer Stromquelle verbunden werden kann, einem zweiten Energiequellenanschluß (12), der mit einer Stromsenke verbunden werden kann, einer ersten supraleitenden Schalteinrichtung (J1), die zwischen den ersten Energiequellenanschluß (10) und Masse (22) geschaltet ist, einer zweiten supraleitenden Schalteinrichtung (J2), die zwischen den zweiten Energiequellenanschluß und Masse (22) geschaltet ist, und einem ersten und einem zweiten Widerstand (14, 16), von denen jeder einen Anschluß aufweist, der mit dem ersten und zweiten Energiequellenanschluß (10, 12) jeweils verbunden ist, während die anderen Anschlüsse des ersten und zweiten Widerstandes (14, 16) zusammengeschaltet sind, um einen Ausgangsanschluß (20) zu bilden, dadurch gekennzeichnet, daß die Schaltung einen dritten und einen vierten Widerstand (26, 28) enthält, von denen jeder einen Anschluß aufweist, der mit einem Steueranschluß der ersten und zweiten supraleitenden Schalteinrichtung (J1, J2) jeweils verbunden ist, während die anderen Anschlüsse des dritten und vierten Widerstandes (26, 28) zusammengeschaltet sind, um einen Eingangsanschluß (24) zu bilden.

2. Supraleitende logische Schaltung nach Anspruch 1, bei der der erste und zweite Widerstand (14, 16) den gleichen Widerstandswert haben.

3. Supraleitende logische Schaltung nach Anspruch 1 oder Anspruch 2, bei der der dritte und der vierte Widerstand (26, 28) den gleichen Widerstandswert haben.

4. Supraleitende logische Schaltung nach einem der vorhergehenden Ansprüche, bei der die erste und die zweite supraleitende Schalteinrichtung (J1, J2) Josephson Übergänge sind, von denen jeder einen Anschluß aufweist, der mit einem Steuereingangsanschluß verbunden ist.

5. Supraleitende logische Schaltung nach einem der vorhergehenden Ansprüche, die weiterhin eine Vielzahl von Widerständen (30, 31, 32) enthält, die mit dem Eingangsanschluß (24) des dritten und vierten Widerstandes (26, 28) verbunden sind und deren andere Anschlüsse jeweilige logische Eingänge liefern.

6. Supraleitende logische Schaltung nach einem der Ansprüche 1 bis 4, bei der der dritte Widerstand (26) eine Vielzahl von Widerständen (26, 26', 26") umfaßt, wobei ein Ende jedes dieser Widerstände (26, 26', 26") mit dem ersten Energiequellenanschluß (10) verbunden ist, und der vierte Widerstand (28) eine Vielzahl von Widerständen (28, 28', 28") umfaßt, wobei ein Ende der Widerstände (28, 28', 28") des vierten Widerstandes mit dem zweiten Energiequellenanschluß verbunden ist und das freie Ende jedes der Widerstände (26, 26', 26") des dritten Widerstandes mit dem freien Ende eines entsprechenden Widerstandes (28, 28', 28") des vierten Widerstandes verbunden ist, um eine entsprechende Vielzahl von Eingangsanschlüssen (24, 24', 24") zu bilden.

7. Supraleitende logische Schaltung nach Anspruch 6, bei der alle Widerstände den gleichen Widerstandswert haben.

8. Supraleitende logische Schaltung nach einem der vorhergehenden Ansprüche, bei der jeder erste und zweite supraleitende Schaltkreis (J1, J2) eine Vielzahl von Schaltkreiseinheiten enthält, die parallel geschalet sind und von denen jede Einheit einen Josephson Übergang (J11, J12) und einen Widerstand (41, 42) aufweist, und bei der der Knotenpunkt (45, 46) zwischen dem Josephson Übergang (J11, J12) und dem Widerstand (41, 42) von wenigstens einer der Schaltkreiseinheiten einen Steueranschluß liefert.

9. Supraleitende logische Schaltung nach Anspruch 8, bei der die Vielzahl von Schaltkreiseinheiten mit dem einen der beiden Energiequellenanschlüsse (10, 12) verbunden ist, der vom gemeinsamen Anschluß (43) der Vielzahl von Schaltkreiseinheiten auf der Seite des Josephson Übergangs gebildet ist, und an ihrem gemeinsamen Anschluß (44) auf ihrer Widerstandsseite an Masse liegt.

10. Supraleitende logische Schaltung nach Anspruch 8, bei der die Vielzahl von Schaltkreiseinheiten mit einem der beiden Energiequellenanschlüsse (10, 12) verbunden ist, die vom gemeinsamen Anschluß (43) der Vielzahl von Schaltkreiseinheiten auf ihrer Widerstandsseite gebildet ist, und an ihrem gemeinsamen Anschluß (44) auf ihrer Seite des Josephson Übergangs an Masse liegt.

## Revendications

1. Circuit logique supraconducteur comprenant une première borne de source d'alimentation (10) conçue pour être connectée à une source de courant, une seconde borne de source d'alimentation (12) conçue pour être connectée à un puits de courant, un premier dispositif de commutation supraconducteur ($J_1$) connecté entre la première borne de source d'alimentation (10) et la masse (22), un second dispositif de commutation supraconducteur ($J_2$) connecté entre la seconde borne de source d'alimentation et la masse (22) et une première et une seconde résistances (14, 16) ayant chacune une borne reliée à la première et à la seconde des bornes de source d'alimentation (10, 12) respectivement, les autres bornes de la première et de la seconde résistances (14, 16) étant reliées ensemble pour former une borne de sortie (20); caractérisé en ce que le circuit comprend une troisième et une quatrième résistances (26, 28) ayant chacune une borne connectée à une borne de commande pour le premier et le second dispositifs de commutation supraconducteur ($J_1$, $J_2$) respectivement, les autres bornes de la troisième et de la quatrième résistances (26, 28) étant connectées ensemble pour former une borne d'entrée (24).

2. Circuit logique supraconducteur selon la revendication 1, dans lequel lesdites première et seconde résistances (14, 16) ont des valeurs de résistance égales.

3. Circuit logique supréconducteur selon la revendication 1 ou 2, dans lequel lesdites troisième et quatrième résistances (26, 28) ont des valeurs de résistance égales.

5. Circuit logique supraconducteur selon l'une quelconque des revendications précédentes, dans lequel lesdits premier et second dispositifs de commutation supraconducteurs ($J_1$, $J_2$) sont des jonctions de Josephson dont chacune possède une borne connectée à une borne d'entrée de commande.

5. Circuit logique supraconducteur selon l'une quelconque des revendications précédentes, caractérisé en ce qu'il comprend en outre une pluralité de résistances (30, 31, 32) connectées à la borne d'entrée (24) desdites troisième et quatrième résistances (26, 28) et ayant leurs autres bornes constituant des entrées logiques respectives.

6. Circuit logique supraconducteur selon l'une quelconque des revendications 1 à 4, dans lequel la troisième résistance (26) comprend une pluralité de résistances (26, 26', 26") une extrémité de chacune de ces résistances (26, 26', 26") étant connectée à la première borne de source d'alimentation (10), et la quatrième résistance (28) comprend une pluralité de résistances (28, 28', 28") une extrémité des résistances (28, 28', 28") de la quatrième résistance étant connectée à la seconde borne de source d'alimentation, l'extrémité libre de chacune des résistances (26, 26', 26") de la troisième résistance étant connectée à l'extrémité libre d'une résistance correspondante (28, 28', 28") de la quatrième résistance pour former une pluralité correspondante de bornes d'entrée (24, 24', 24").

7. Circuit logique supraconducteur selon la revendication 6, dans lequel toutes lesdites résistances ont des valeurs de résistance égales.

8. Circuit logique supraconducteur selon l'une quelconque des revendications précédentes, dans lequel chacun desdits premier et second circuits de commutation supraconducteurs ($J_1$, $J_2$) comprend une pluralité d'unités de circuit qui sont connectées en parallèle et dont chacune des unités possède une jonction de Josephson (J11, J12) et une résistance (41, 42) et dans lequel le noeud (45, 46) entre la jonction de Josephson (J11, J12) et la résistance (41, 42) de l'une au moins desdites unités de circuit constitue une borne de commande.

9. Circuit logique supraconducteur selon la revendication 8, dans lequel ladite pluralité d'unités de circuit sont connectées avec l'une ou l'autre desdites première et seconde bornes de source d'alimentation (10, 12) formées par la borne commune (43) de la pluralité des unités de circuit du côté de leur jonction de Josephson et sont mises à la masse à leur borne commune (44) du côté de leur résistance.

10. Circuit logique supraconducteur selon la revendication 8, dans lequel ladite pluralité d'unités de circuit sont connectées avec l'une ou l'autre desdites première et seconde bornes de source d'alimentation (10, 12) formées par la borne commune (43) de la pluralité des unités de circuit du côté de leur résistance et sont mises à la masse sur leur borne commune (44) du côte de leur jonction de Josephson.

FIG. 1
PRIOR ART

FIG. 2
PRIOR ART

FIG. 3
PRIOR ART

FIG. 4
PRIOR ART

1

# FIG. 5A

# FIG. 5B

# FIG. 5C

# FIG. 6A

# FIG. 6B

## FIG. 7A

## FIG. 7B

0 069 534

# FIG. 8

5

FIG. 9